# EUROPEAN PATENT SPECIFICATION

(11) **EP 1 576 202 B1**
(45) Date of publication and mention of the grant of the patent: **29.05.2013**
(21) Application number: 03813599.2
(22) Date of filing: 22.12.2003
(51) Int. Cl.: C23C 14/56, C23C 16/54, B21C 37/04, C23C 14/02, C23C 14/16, C23C 14/58

(54) **METHODS FOR PRODUCING COATED METAL WIRE**
VERFAHREN ZUR HERSTELLUNG VON BESCHICHTETEM METALLDRAHT
PROCEDES DE PRODUCTION D'UN FIL METALLIQUE REVETU

(30) Priority: 23.12.2002 WO PCT/IT02/00823
(43) Date of publication of application: 21.09.2005
(73) Proprietor: Pirelli Tyre S.p.A., 20126 Milano (IT)
(72) Inventor: PAVAN, Federico, I-50136 Firenze (IT); AGRESTI, Simone, I-50047 Prato (IT); CAVALLOTTI, Pietro, Luigi, I-20131 Milano (IT); NOBILI, Luca, I-20100 Milano (IT)
(74) Representative: Bottero, Claudio
(86) International application number: PCT/EP2003/014810
(87) International publication number: WO 2004/057053

(56) References cited:
- EP-A- 0 241 721
- EP-A- 0 265 992
- EP-A- 0 669 409
- GB-A- 1 300 487
- US-A- 3 055 089
- US-A- 4 725 340
- US-A- 4 988 552
- US-A- 5 219 668
- US-A- 5 403 419

## Description

### Field of the invention

The present invention refers to a method for producing a metal wire intended to reinforce elastomeric materials, such as for example semi-finished products intended for the manufacture of tires, tubes, conveyor belts, transmission belts and cables.

In particular, the present invention refers to a metal wire of the type comprising a metal core and a metal coating layer.

In the present description and in the following claims, the term "metal" is used to indicate both a single metal and a metal alloy.

The present invention also refers to a metal wire intended to reinforce elastomeric materials, of the type comprising a metal core and a metal coating layer, as well as to a metal cord comprising a plurality of such metal wires and to a method for producing the same.

### Prior art

Methods for producing metal wires comprising a metal core and a metal coating layer and intended to reinforce elastomeric materials, such as for example semi-finished products intended for the manufacture of tires, are known. The latter are commonly reinforced by embedding metal wires or metal cords (comprising a plurality of metal wires stranded together) in an elastomeric material to form, for example, the belt layers of a tire. The metal core of such wires is provided with a metal coating layer to carry out the dual function of providing a suitable corrosion resistance to said wires and of ensuring a good adhesion thereof to the vulcanized elastomeric material.

For example, methods for producing brassed steel wires essentially involving the steps described hereafter are known:
- an electrodeposition step in two distinct electrolytic baths, in which a coppering and, respectively, a zinc plating of the steel core are successively carried out;
- a thermal treatment step of zinc diffusion into copper thus deposited to form the brass alloy;
- a pickling step in acid solution, typically phosphoric acid, for removing the zinc oxides formed on the surface due to the thermal diffusion treatment step; and
- a drawing step aimed at obtaining a predetermined diameter and a predetermined mechanical resistance of the brassed wire.

Conventional methods of such type, although substantially suitable for the purpose, nevertheless have a series of drawbacks which have not been overcome yet, such as the excessive number of steps, the excessive duration of the above-mentioned diffusion step and the reduction of mechanical resistance of the wire following such a diffusion step. Furthermore, in the brass coating layer there are undesired gradients of concentration of copper in the radial direction and in the axial direction of the wire, as well as a variability of the amount of brass both in the axial direction and in the radial direction of the wire.

More specifically, the variations of the copper percentage in the radial direction of the wire reach values equal to about ±3% by weight, the radially outermost zone of the brass layer generally being richer in zinc and the radially innermost zone of the brass layer, i.e. the zone at the interface with the steel, being richer in copper. The variations of the copper percentage in the axial direction of the wire reach values equal to about ±2% by weight. As to the variations of the brass amount, these reach values of 0.5 g of brass/kg of steel both in the axial direction and in the radial direction of the wire, whereby the thickness of the brass layer is not uniform.

In addition to the above-mentioned drawbacks, β brass with a body-centered cubic structure might form. The presence of β brass, particularly when in a concentration of more than 10% by weight, makes the drawing step extremely difficult and results in an excessive wear of the drawing dies, as well as the risk that there are areas of wire not completely coated and/or containing unacceptable amounts (in the order of about 50 mg/m²) of impurities, such as oxides deriving not only from the acid used in the above-mentioned pickling step, but also from the oxides present in the coppering bath and from those present in the lubricant used in the drawing step.

Methods for coating metal wires are also known, such as for example the method described in US patent 4,517,066, which provide, for the purpose of obtaining a suitable adhesion of the coated wire to the elastomeric materials, to carry out a deposition step by sputtering for applying an extremely thin metal film on the core of the wire. However, the metal film is so thin (from some Å to 0.4 µm) that there is the risk that more or less large areas of the surface of the core are not perfectly coated or that surface areas, although substantially coated, present surface defects, thus not ensuring a suitable corrosion resistance of the wire.

In the same way, in order to obtain a suitable adhesion of the coated wire to elastomeric materials, in US patent 5,403,419 a method for coating metal wires is described in which a thin metal film is deposited by means of vacuum deposition, ion plating, DC or RF magnetron sputtering, bipolar sputtering or RF sputtering processes.

GB1300487 discloses coating a steel wire with brass by sputtering and EP669409 discloses coating a steel wire with a zinc/cobalt alloy and drawing the coated wire to a smaller dimension.

### Summary of the invention

The Applicant has perceived the necessity of providing a method for producing a metal wire intended to reinforce elastomeric materials, of the type comprising a metal core and a metal coating layer, which allows to obtain a wire having suitable mechanical strength in view of the incorporation of the wire into elastomeric materials to be reinforced and comprising a coating layer of high quality, in particular with reference to the uniformity and homogeneity thereof, and improved corrosion resistance, with a positive effect upon the adhesion of the wire to elastomeric materials.

In accordance with a first aspect thereof, the present invention relates to a method for producing a metal wire for reinforcing an elastomeric material, the metal wire comprising a metal core and a metal coating layer, said core having a predetermined initial diameter, said method comprising the steps of:
a) submitting the metal core to at least one surface treatment for predisposing the surface of the core to being coated with said coating layer;
b) thermally treating said core;
c) depositing said metal coating layer to a predetermined initial thickness on said thermally treated core by means of a plasma deposition technique; and
d) drawing the coated core until the core has a final diameter smaller than said predetermined initial diameter and the metal coating layer has a final thickness smaller than said predetermined initial thickness.

In the following description and in the subsequent claims, the expressions "initial diameter of the core" and "initial thickness of the coating layer" are used to indicate the diameter of the core and, respectively, the thickness of the coating layer before the drawing of the coated core.

In the following description and in the subsequent claims, the expressions "final diameter of the core" and "final thickness of the coating layer" are used to indicate the diameter of the core and, respectively, the thickness of the coating layer after the drawing of the coated core.

In the following description and in the subsequent claims, the expression "plasma deposition technique" is used to indicate any deposition technique which uses plasma as means for activating the vaporization of the metal to be deposited (such as for example in sputtering and in evaporation by voltaic arc), as carrier for the metal to be deposited (such as for example in plasma spray) or as means for dissociating the process gases (such as for example in plasma enhanced chemical vapor deposition (PECVD)) in a vacuum deposition chamber.

Firstly, thanks to the fact that the metal core is superficially treated so as to predispose the surface of the core to being coated, i.e. to obtain a core adapted to uniformly receive the coating layer on the whole surface thereof, it is advantageously possible to obtain a wire of improved quality. In other words, any macrorugosity or unevenness of the core surface deriving from the thermal treatment is advantageously substantially eliminated, thus rendering the core surface suitable for the deposition of the coating layer thereon. This advantageous effect is particularly desirable if the core is made of a metal having a very rough surface, such as for example steel.

Secondly, thanks to the fact that the metal core is thermally treated, a structure suitable for a cold deformation, such as the deformation involved in the drawing step, is advantageously imparted to the metal core.

Furthermore, thanks to the fact that the metal coating layer is deposited by means of a plasma deposition technique, it is advantageously possible to obtain a wire coated in a uniform and homogeneous manner.

In other words, it is advantageously possible to obtain a wire coated in such a manner as to minimize both the variations of the amount of metal deposited in the axial direction and in the radial direction of the wire. Furthermore, in the case of deposition of layers consisting of metal alloys, the formation of concentration gradients of each component of said alloys in the axial direction and in the radial direction of the wire is advantageously reduced. Such characteristics of uniformity and homogeneity of the coating layer are particularly important for the purposes of obtaining the desired properties of corrosion resistance.

A deposition based on a plasma technique advantageously allows to form a finished coating layer in a faster manner with respect to the formation of the finished coating layer in the electrodeposition methods of the prior art since the method of the present invention does not require a thermal diffusion treatment step after the application of the metal coating layer - the thermal diffusion treatment step being provided, in the methods of the prior art, downstream of the electrodeposition - nor a subsequent pickling step in phosphoric acid.

The elimination of the thermal diffusion treatment in turn allows to eliminate the inevitable reduction of the mechanical resistance - due to such thermal diffusion treatment - of the wires produced with the methods of the prior art.

Furthermore, the plasma deposition technique allows to obtain a coating layer having a crystalline structure conveniently deformable in the subsequent drawing step. Thus, for example, if the metal coating layer comprises brass, the plasma deposition technique allows to obtain a layer of brass having a crystalline structure consisting of α brass (face-centered cubic). The deformability of α brass facilitates the subsequent drawing step, while allowing at the same time a reduction of the wear of the drawing dies with respect to the wear involved in the drawing of wires coated with a layer of brass containing β brass (body-centered cubic).

Furthermore, the amount of impurities, such as for example oxides, present in the coating layer is drastically reduced with respect to the amount present in the wires produced by the electrodeposition methods of the prior art.

Preferably, the above-mentioned surface treatment, thermal treatment, deposition and drawing steps of the method according to the invention are carried out in a substantially continuous manner.

In the following description and in the subsequent claims, the expression "in a substantially continuous manner" is used to indicate the absence, between the various steps of the production method, of intermediate storages of semi-finished products, so as to continuously produce a coated wire having undefined length or, following the stranding of a plurality of such coated wires, a metal cord of undefined length in a single production line.

In accordance with a preferred embodiment of the method of the invention, the core of the wire is conveyed through a sequence of respective surface treatment, thermal treatment, deposition and drawing positions at a speed comprised in the range from about 10 to about 80 m/min.

In such a way, it is advantageously possible to obtain a metal wire coated with a metal coating layer having a desired thickness by means of a single productive process carried out in a substantially continuous manner from the step of producing the metal core of the wire to the step of drawing the coated core, optionally including additional conventional preliminary treatments effected on the core or additional finishing treatments effected on the coated core (e.g. a phosphating treatment of the core or of the coated core in order to improve the drawing thereof).

It is also advantageously possible to carry out additional manufacturing processes intended to produce a final product by using the coated core as starting product. By way of illustrative example, in order to produce a metal cord comprising a plurality of coated metal wires, a stranding step of said plurality of coated metal wires may be provided after the drawing step carried out on the coated core.

The production method may optionally also include a series of preliminary steps aimed at obtaining a metal core of a predetermined diameter starting from a wire rod.

For example a mechanical removal of the oxides present on the wire rod, known in the field with the term of descaling, may be carried out. The descaling step is carried out to smooth the wire rod, i.e. to substantially eliminate the roughness thereof In such way, any surface roughness, for example in the form of peaks and valleys at the outer surface of the wire rod, which may have a remarkable depth in the case of a rod made of steel, typically in the range of from about 1.5 µm to 2.0 µm, is advantageously eliminated, thus improving the adhesion of the coating to the core in the successive depositing step and the effectiveness of the deposition step. The descaling step is preferably followed by a dry drawing of the wire rod, at the end of which a wire core having a predetermined initial diameter is obtained.

Subsequently to these preliminary steps, according to the method of the invention, the metal core undergoes a surface treatment which aims to remove oxides possibly present on the metal core surface. The surface treatment preferably comprises the steps of pickling, washing and optionally drying the metal core. The pickling step is carried out by introducing the metal core into a pickling bath, such as for example a bath containing sulfuric acid. Successively, the pickled core is washed by means of water and optionally dried, preferably by means of hot air produced by a blower (e.g. at a temperature comprised from about 70°C to about 90°C, more preferably at a temperature of about 80°C).

Alternatively to the pickling step, the core may undergo alternative surface treatments, such as for example etching, cleaning and activation by a plasma etching technique, for example by conveying argon ions onto the core surface.

According to a preferred embodiment, the method of the invention further comprises the step of dry drawing the core before said thermal treatment, preferably in such a manner to obtain a slight reduction of the core diameter, such as for example comprised between about 1 and about 3%.

According to an alternative embodiment of the method of the invention, the above-mentioned surface treatment, such as for example the pickling or any other alternative treatment suitable for the purpose, may be carried out on a wire rod, preferably preliminarily descaled, and the surface treatment is followed by a dry drawing aimed at obtaining a metal core having a predetermined initial diameter.

Successively, according to the method of the invention, a thermal treatment is carried out on the metal core. By way of indication only, said thermal treatment of the metal core preferably comprises the step of gradually heating the core to a predetermined temperature, such as for example comprised between about 900°C and about 1000°C, and the subsequent step of cooling the core to a predetermined temperature, such as for example comprised between about 530°C and about 580°C. Preferably, the cooling step is carried out by introducing the metal core into a molten lead bath. Alternatively, the cooling step is carried out by introducing the metal core into a bath of molten salts (i.e. chlorates, bicarbonates), by passing the metal core through zirconium oxide powders or by means of air.

The method of the present invention preferably further comprises a further thermal treatment, which is preferably carried at the same working conditions mentioned above and which comprises a further gradual heating step and a subsequent cooling step of the metal core.

When a first and a second thermal treatment are provided, a further dry drawing is preferably carried out after the first thermal treatment. If additional thermal treatments are provided, a dry drawing between each couple of thermal treatments is preferably carried out.

When a single thermal treatment is provided, a further slight dry drawing is preferably carried out by using a drawing die which is preferably connected in an gas-tight manner with the vacuum deposition chamber, at the inlet thereof. More preferably, such slight drawing step may be carried out by means of a so-called split drawing die, which essentially comprises a drawing die having two symmetrical halves. Thanks to this feature, the drawing die may be advantageously substituted in a simple manner, without interrupting the production process.

Subsequently to said thermal treatment(s), the method of the present invention further comprises the plasma deposition step mentioned above, which is preferably carried out in at least one vacuum deposition chamber at a first predetermined pressure.

In accordance with a preferred embodiment of the method of the invention, the above-mentioned plasma deposition technique is selected from the group comprising: sputtering, evaporation by voltaic arc, plasma spray and plasma enhanced chemical vapor deposition (PECVD).

Preferably, the deposition technique used by the method of the invention is sputtering. In such a case, the control of the composition of a coating layer consisting of an alloy is advantageously improved and simplified since, in order to obtain an alloy having a desired composition, it is sufficient to use a cathode consisting of an alloy of such a composition.

In order to carry out a sputtering, it is possible to use at least one conventional vacuum deposition chamber provided with a vacuum pump suitable for creating a predetermined pressure and with means for supplying a carrier gas. In the at least one vacuum deposition chamber at least one cathode is provided consisting of the metal to be deposited, for example in the form of a tube in which the core of the wire to be coated, constituting the anode, is made to pass through. Alternatively, the at least one cathode may be provided in the form of a circular or rectangular plate in which or, respectively, parallel to which, the anode is made to pass.

Sputtering essentially consists of a ionic bombardment of the cathode, typically at an energy equal to about 200-500 eV, with ions of the carrier gas obtained under the action of an electrical field generated by applying a voltage between the cathode and the anode. More specifically, ions of the carrier gas are accelerated towards the cathode, essentially causing a series of collisions with a consequent emission of cathode atoms directed towards the anode, i.e. towards the core, towards which free electrons are also accelerated. The free electrons ionize by collision further atoms of carrier gas, whereby the process repeats itself and self-sustains as long as sufficient energy is supplied.

Preferably, the deposition technique is magnetron sputtering which, thanks to the effect exerted by the magnetic field on the electrically charged particles, and in particular thanks to a confinement action of the electrons in proximity of the cathode and to an increase of the plasma density, allows to increase the deposition rate.

Alternatively, a deposition by voltaic arc technique can be used, the latter consisting of an ionic or electronic bombardment, typically at an energy in the order of 100 eV, of the metal to be deposited.

The plasma deposition technique may also consist of the so-called plasma spray, essentially consisting of feeding a plasma flow of fine powders of the metal to be deposited, preferably having a size of about 0.1 µm. The powders, accelerated and heated by the plasma until the melting point of the metal is reached, are directed onto the metal core to be coated, thus creating a coating consisting of a plurality of overlaying layers of metal particles.

The plasma deposition technique by means of which the above-mentioned deposition step of the method of the invention is carried out may also be plasma enhanced chemical vapor deposition (PECVD). Such a technique essentially consists of the plasma dissociation of precursor gases in a vacuum chamber (for example at a pressure equal to about 0.1-10 Torr). Preferably, the precursor gases comprise metallorganic compounds, such as for example (hexafluoroacetylacetonate)copper(trimethylvinylsilane) ((hfac)Cu(VTMS)), (hexafluoropentadionate)copper(vinyltrimethoxysilane) ((hfac)Cu(VTMOS)), diethylzinc and diphenylzinc, which advantageously have low decomposition temperatures, in the order of 25-80°C.

According to a further preferred embodiment, the method of the invention comprises the steps of providing a first vacuum deposition chamber and a second vacuum deposition chamber which are arranged in series, each of said vacuum deposition chambers being at a first predetermined pressure, and of depositing the metal coating layer in at least one of said vacuum deposition chambers at said first predetermined pressure by conveying the core to be coated in succession through said vacuum deposition chambers.

The device intended to perform the plasma deposition technique of the second vacuum deposition chamber may be put in stand by mode. In such way, it is not necessary to interrupt the production process to substitute the source of the metal to be deposited onto the core, e.g. the metal cathode in a sputtering process. Such substitution of the source of metal intended to form the coating layer, which must be effected when the metal source is totally consumed or a different metal has to be deposited, may be advantageously made in the first of the two vacuum deposition chambers while the second of the two vacuum deposition chambers is switched to an operative mode, thus avoiding production stops and resulting in an increase of the productivity of the method of the invention.

Advantageously, in addition to the possibility of substituting the metal source to be deposited on the core without interrupting the production process as described above, such preferred embodiment of the method of the invention allows to obtain different wires in a substantially simultaneous manner by switching to an operative mode both chambers and setting different deposition conditions or by providing metal sources having different compositions in the two vacuum deposition chambers both set in an operative mode.

The core is preferably conveyed through said at least one vacuum deposition chamber according to a path such as to be subject to the above-mentioned deposition step a plurality of times. In other words, the wire is passed back along a deposition zone of the at least one vacuum deposition chamber for a predetermined number of times.

In such a way, it is advantageously possible to deposit a metal coating layer to a suitable initial thickness also on a core maintained at a high conveying speed, in the order of 80 m/min. For illustrating purposes, the core may be conveyed, for example by means of suitable means for feeding back the core arranged in the at least one vacuum deposition chamber, according to a forward and backward path to be covered for a predetermined number of times which increases the residence time of the core in such at least one vacuum deposition chamber until a desired initial thickness of the coating is achieved.

Furthermore, a preferred embodiment of the method of the invention provides that the deposition step is carried out simultaneously on a plurality of cores conveyed along a predetermined conveying direction, so as to advantageously increase the productivity of the method.

Preferably, the metal core is coated in at least one vacuum deposition chamber subject to a first predetermined pressure, which is preferably comprised between about 10⁻³ mbar and about 10⁻¹ mbar when the plasma deposition technique is sputtering, more preferably in the order of 10⁻² mbar.

By way of illustrative example, the method of the invention allows to deposit a coating layer, for example made of brass, having a suitable thickness in the order of some microns, preferably comprised from about 0.5 µm to about 2 µm, more preferably of about 1.5 µm, on a core for example made of steel, at a pressure comprised in the above-mentioned preferred range of values.

Preferably, the method of the invention further comprises the step of conveying the core in at least one pre-chamber subject to a second predetermined pressure higher than said first predetermined pressure, said at least one pre-chamber being arranged upstream of said at least one vacuum chamber.

In such way, the desired vacuum condition is advantageously achieved in at least two subsequent steps, i.e. in a stepwise manner, which is simpler and more convenient from an economical point of view with respect to the achievement of a vacuum condition in a single step.

Furthermore, the provision of at least one pre-chamber advantageously allows to preserve the vacuum deposition chamber (in which the depositing step is carried out) from the contamination of dusts and external agents in general, such as oxygen, which are detrimental to the effectiveness of the depositing step and to the purity of the metal of the coating layer to be deposited. Such advantageous effect can simply be achieved by introducing in the at least one pre-chamber a flow of a chemically inert gas.

Preferably, for such a purpose the at least one pre-chamber contains the same gas used as carrier gas in the at least one vacuum deposition chamber, thus allowing to use a supply of gas of the same type both for the at least one pre-chamber and for the at least one vacuum deposition chamber.

More preferably, the above-mentioned chemically inert gas is argon, which is convenient from an economical point of view, resulting in a limitation of the production costs.

Preferably, a further pre-chamber subject to the above-mentioned second predetermined pressure is provided downstream of the at least one vacuum deposition chamber.

Preferably, said second predetermined pressure is comprised between about 0.2 and about 10 mbar, more preferably in the order of about 1 mbar.

According to a further preferred embodiment, the method of the invention comprises the step of providing a first and a second vacuum deposition chambers arranged in series as described above, the first vacuum deposition chamber being arranged downstream of a first pre-chamber as described above and the second vacuum deposition chamber being arranged downstream of a second pre-chamber separating the two vacuum deposition chambers, a third pre-chamber being arranged downstream of the second vacuum deposition chamber.

In such way, in addition to the above-mentioned advantageous achievement of the desired vacuum condition in a stepwise manner, it is advantageously possible both to substitute the metal source in the first vacuum deposition chamber by switching the first vacuum deposition chamber to a stand by mode and by switching the second vacuum deposition chamber to an operative mode, and to set different deposition conditions or provide different metal sources in the two vacuum deposition chambers by putting both vacuum deposition chambers into an operative mode.

Preferably, the core is made of a different metal with respect to the metal of which the coating layer is made.

In such way, the metal of the core may be selected among the metals more suitable for carrying out a mechanical supporting function, while the metal of the coating layer may be selected among the metals more suitable for obtaining a suitable adhesion between the metal wire and an elastomeric material, and a suitable corrosion resistance. Thanks to these features, it is advantageously possible to produce metal wires or metal cords (comprising a plurality of metal wires stranded together) intended to reinforce an elastomeric material to form, for example, tires, tubes, conveyor belts, transmission belts and cables having a good quality.

Preferably, the metal core is made of steel, which is a particularly suitable material for reinforcing elastomeric materials such as for example semi-finished products intended for the manufacture of belt layers of a tire.

The metal coating layer may comprise a metal or a binary or ternary metal alloy.

Preferably, the coating metal is selected from the group comprising: copper, zinc, manganese, cobalt, tin, molybdenum, iron and their alloys.

Still more preferably, the coating metal is brass. Advantageously, a wire comprising a core coated with a layer of brass is provided with a high corrosion resistance.

In accordance with a preferred embodiment, the coating metal is brass having a copper content of from about 60 to about 72% by weight, more preferably of from about 64 to about 67% by weight.

If copper is present in a percentage lower than 60% by weight, in fact, there is the undesired formation of β brass while, if copper is present in a percentage greater than 72% by weight, the wire is excessively reactive with the elastomeric material which the wire is intended to reinforce. Such a reactivity of the wire with the elastomeric material causes the formation on the wire of a thick layer of sulfides which causes an undesired worsening of the wire properties. As a consequence, in the above-mentioned preferred range of values of copper composition, the formation of β brass is advantageously avoided, while maintaining the reactiveness of the wire with elastomeric materials at an acceptable level.

Preferably, the coating metal is an alloy selected from the group consisting of: Zn-Co, Zn-Mn, Cu-Zn-Mn, Zn-Co-Mo, Cu-Zn-Sn.

By coating the metal core with one of such alloys, the corrosion resistance of the wire is further improved.

Preferably, the method of the invention comprises the step of depositing a coating metal consisting of a ternary Cu-Zn-Mn alloy having a composition 63% Cu, 34% Zn, 3% Mn.

The preferred composition of the Zn-Co alloy is 99% Zn, 1% Co, the preferred composition of the Zn-Mn alloy is 98% Zn, 2% Mn, the preferred composition of the Zn-Co-Mo alloy is 99% Zn, 0.5% Co, 0.5% Mo, while the preferred composition of the Cu-Zn-Sn alloy is 67% Cu, 30% Zn, 3% Sn.

Preferably, said coating metal further comprises a predetermined amount of a lubricating agent intended to facilitate the drawing of the metal wire.

In such way, the drawability of the wire is advantageously improved.

Such embodiment is particularly preferred when the coating layer comprises a material having poor drawability, such as for example a Zn-Mn alloy.

More preferably, the lubricating agent is selected from the group comprising: phosphorous containing compounds (e.g. organic phosphates), sulfur containing compounds (e.g. thiols, thioesters, thioethers), chlorine containing compounds (e.g. organic chlorides). Preferably, said lubricants are the so-called "Extreme Pressure Lubricants", i.e. lubricants which decompose at high temperature and pressure (e.g. giving rise to the formation of phosphides, sulphides and chlorides of iron, copper or zinc).

Still more preferably, the coating material comprises a predetermined amount of phosphorous. Advantageously, the drawability of a metal wire including a coating layer comprising a predetermined amount of phosphorous is improved without affecting the adhesion of the coating layer to the elastomeric material in which the wire is intended to be embedded.

Preferably, the coating material comprises phosphorous in an amount of about 1-3% by weight, more preferably in an amount of about 2% by weight, with respect to the total weight of the coating metal.

Advantageously, by including phosphorous in such preferred amount in the metal to be deposited onto the metal core, e.g. by providing a cathode containing phosphorous, the plasma deposition step involved in the method of the invention allows to deposit a metal coating layer comprising phosphorous exactly in the same amount (i.e. 1-3%) in an uniform manner. Therefore, since phosphorous is uniformly present in the whole thickness of the coating layer, the subsequent drawing step is improved thanks to the lubricating action of the phosphorous, independently of the drawing degree which has been set.

Furthermore, thanks to the fact that the coating layer is deposited by means of a plasma deposition technique, the percentage variation of the amount of said lubricating agent in said coating layer is lower than about 1% by weight, more preferably comprised between about 0.01% and about 1% by weight, in the radial direction of the wire with respect to the weight of the metal forming the coating layer.

In an analogous manner, the percentage variation of the amount of said lubricating agent in said coating layer is lower than about 1% by weight, more preferably comprised between about 0.01 % and about 1% by weight, in the axial direction of the wire with respect to the weight of the metal forming the coating layer.

Preferably, the initial thickness of the metal coating layer is at least about 0.5 µm.

Still more preferably, the initial thickness of the metal coating layer is between about 0.5 and about 2 µm.

In such a way, a suitable value of the initial thickness of the metal coating layer in view of the drawing step of the coated core is obtained, which allows to obtain the desired value of final diameter of the core and an advantageous increase of the properties of mechanical resistance of the wire. For illustrative purposes, a wire having an initial breaking load - i.e. before the drawing step of the coated core - equal to about 1200 MPa can reach - due to the drawing step of the coated core - a final breaking load of about 3200 MPa.

Preferably, the drawing step is carried out in such a way as to obtain a core having a final diameter which is reduced of about 75-95% with respect to the initial diameter of the core, more preferably of about 80-90% and, still more preferably, of about 85% with respect to the initial diameter.

In accordance with a preferred embodiment of the method of the invention, the drawing step is carried out in such a way as to obtain a coating layer having a final thickness which is reduced by about 75-95% with respect to the initial thickness of the coating layer, more preferably by about 78-88% and, still more preferably, by about 83% of the initial thickness.

Preferably, the initial diameter of the core is comprised between about 0.85 mm and about 3 mm and the drawing step is carried out in such a way as to obtain a core having a final diameter comprised in the range 0.10-0.50 mm.

Preferably, the initial thickness of the coating layer is comprised between about 0.5 and about 2 µm and the drawing step is carried out in such a way as to obtain a metal coating layer having a final thickness comprised in the range 80-350 nm.

In accordance with a second aspect thereof, the present disclosure relates to a metal wire intended to reinforce elastomeric materials, of the type comprising a metal core and a metal coating layer, obtained by means of the above-mentioned production method.

Advantageously, thanks to the features of the method of the invention defined above, the wire of the present disclosure comprises a uniform and homogeneous metal coating layer and has an improved mechanical resistance.

Furthermore, a wire comprising a layer of brass having a crystalline structure consisting of α brass, which is easily deformable in the subsequent drawing step, is advantageously obtained.

Advantageously, a metal wire produced by the method of the invention comprises a metal coating layer substantially free of impurities.

Preferably, the coating metal is brass and the percentage variation of the amount of copper in the coating layer is lower than about 1 % by weight in the radial direction of the wire.

Preferably, the metal core is made of a different metal with respect to the metal of which the coating layer is made.

Preferably, the metal core is made of steel.

Preferably, the coating layer is made of brass having a copper content of from about 60 to about 72% by weight, more preferably of from about 64 to about 67% by weight.

Preferably, the percentage variation of the amount of copper in the coating layer is lower than 0.5% by weight in the axial direction of the core.

In accordance with a further preferred embodiment of the present disclosure the variation by weight of the amount of brass in the coating layer is lower than about 0.15 g of brass/kg of steel in the axial direction of the wire.

Preferably, the variation by weight of the amount of brass in the coating layer is lower than about 0.15 g of brass/kg of steel in the radial direction of the wire.

Preferably, the coating metal of the wire of the present disclosure consists of a ternary Cu-Zn-Mn alloy having a composition 63% Cu, 34% Zn, 3% Mn.

The preferred composition of the Zn-Co alloy is 99% Zn, 1% Co, the preferred composition of the Zn-Mn alloy is 98% Zn, 2% Mn, the preferred composition of the Zn-Co-Mo alloy is 99% Zn, 0.5% Co, 0.5% Mo, while the preferred composition of the Cu-Zn-Sn alloy is 67% Cu, 30% Zn, 3% Sn.

Preferably, the wire of the present disclosure comprises a core having a diameter comprised in the range 0.10-0.50 mm. Preferably, the wire of the present disclosure comprises a metal coating layer having a thickness comprised in the range 80-350 nm.

Finally, the present disclosure relates to a method for producing a metal cord intended to reinforce elastomeric materials.

### Brief description of the drawings

Additional features and advantages of the invention will become more readily apparent from the description of some preferred embodiments of a method according to the invention for producing a metal wire intended to reinforce elastomeric materials, of the type comprising a metal core and a metal coating layer, made hereafter with reference to the attached drawings in which, for illustrative and not limiting purposes, two flow diagrams of said method are represented.

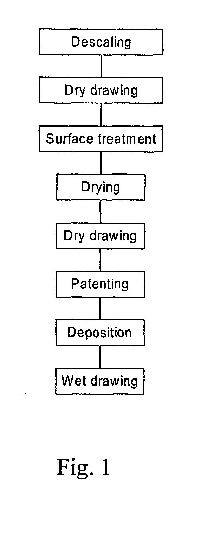

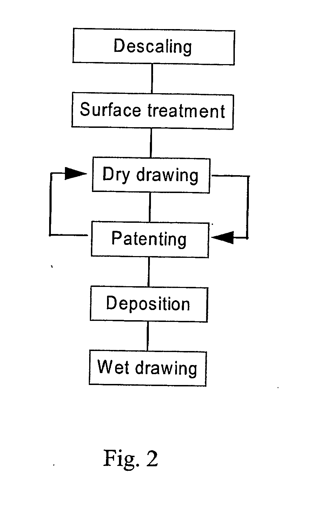

In the drawings, figures 1 and 2 are two flow diagrams which illustrate respective preferred embodiments of the method of the invention for producing a metal wire intended to reinforce elastomeric materials, of the type comprising a metal core and a metal coating layer.

### Detailed description of the preferred embodiments

A preferred embodiment of the method of the invention for producing a metal wire intended to reinforce elastomeric materials, of the type comprising a metal core and a metal coating layer, is illustrated in a flow diagram shown in figure 1.

With reference to such a figure, the method of the invention comprises the descaling of a metal wire rod.

The descaling step is followed by a dry drawing of the wire rod, at the end of which a wire core having a predetermined initial diameter is obtained.

The metal core so obtained is submitted to at least one surface treatment intended to predispose the core surface to being coated by the coating layer.

Alternatively, as shown in figure 2, the surface treatment is carried out on the metal wire rod descaled and the drawing aimed at obtaining a wire core having a predetermined initial diameter is carried out on the wire rod superficially treated.

The surface treatment step preferably comprises the step of electrolytically pickling the core (fig. 1)/the rod (fig. 2) into a bath containing for example sulfuric acid, and by subsequently washing the pickled core in water. With reference to fig. 1, subsequently, in order to eliminate any residual water from the washed core, the core is dried, for example by means of hot air at about 80°C produced by a blower arranged downstream of the washing step.

As shown in figure 1, the drying step is followed by a dry drawing step and by a thermal treatment, for example by means of a patenting thermal treatment carried out in a furnace.

All the steps of the method are preferably carried out in a substantial continuous manner.

As shown in figure 2, the dry drawing and the thermal treatment step may be carried out a plurality of times in case substantial section reductions are desired or in case metals having a high tensile breaking load are treated, such as for example in the case of steels with a carbon content equal to about 0.8% by weight.

In a step of the method of the invention subsequent to the thermal treatment step, a metal coating layer is deposited to a predetermined initial thickness on the metal core so treated by means of a plasma deposition technique.

In accordance with a preferred embodiment of the method of the invention, the plasma deposition technique may, for example, be the sputtering technique.

Preferably, the metal core is coated in at least one vacuum deposition chamber subject to a first predetermined pressure, which is preferably comprised between about 10⁻³ mbar and about 10⁻¹ mbar.

In order to avoid any interruption in the sputtering process due to the consumption of the metal to be deposited or due to a change of production, e.g. a change of the type of coating layer, the deposition of the coating layer is carried out in a first vacuum deposition chamber, a second vacuum deposition chamber being arranged in series with the first one and being set in a stand by mode. Both first and second vacuum deposition chambers contain a carrier gas, such as for example argon, at a predetermined first pressure, preferably comprised between about 10⁻³ mbar and about 10⁻¹ mbar.

In particular, before being conveyed in the first vacuum deposition chamber, in order to preserve the first and, when used, the second vacuum deposition chamber from dust and other contaminants, a first pre-chamber and a second pre-chamber arranged upstream of the first and, respectively, the second vacuum deposition chamber, are provided.

A third pre-chamber is further provided downstream of the second vacuum deposition chamber. In other words, the first pre-chamber, the first vacuum deposition chamber, the second pre-chamber, the second vacuum deposition chamber and the third pre-chamber are successively arranged in series.

The first, the second and the third pre-chambers contain argon subject to a second predetermined pressure higher than said first predetermined pressure, for example in the order of 0.5 mbar.

In such way, the desired vacuum condition of 10⁻³ mbar-10⁻¹ mbar is advantageously achieved in each vacuum deposition chamber in a stepwise manner.

In the first and second vacuum deposition chamber two respective cathodes are provided consisting of the metal to be deposited, for example brass, preferably in tubular or plate-shaped form. Furthermore, in each vacuum deposition chamber a respective anode is provided, consisting of the core to be coated. In order to carry out the above-mentioned deposition step, each anode is introduced into the respective tubular cathode or, respectively, is made to pass parallel to the respective plate-shaped cathode.

In the first and second vacuum deposition chamber a plurality of means for feeding back the core is preferably provided in order to increase the residency time of the core in each vacuum deposition chamber, thus allowing the achievement of the desired initial thickness of the coating also at high conveying speeds of the core, preferably comprised between about 10 and about 80 m/min.

Preferably, the sputtering is carried out by setting a pressure in the order of 10⁻³-5·10⁻² mbar, a voltage applied to the electrodes comprised between about 100 and about 1000

V and a current comprised between about 0.1 and about 10 A. Due to the consequent discharge, ions of the carrier gas are accelerated towards the cathode of the metal to be deposited and atoms of such a metal are vaporized towards the core to be coated.

By complying with the above-mentioned preferred voltage, current and gas pressure values, a deposition rate of the brass comprised in the range from about 100 to about 1000 nm/min, depending on the distance between the cathode and the anode and on the shape of the cathode, is advantageously achieved. A distance between the cathode and the anode ranging from about a few cm to some tens of cm as a function of the size and shape of the cathode has been found particularly preferred in terms of effectiveness of deposition.

In accordance with a subsequent step of the method of the invention, the core thus coated is drawn until a core having a final diameter lower than the predetermined initial diameter and a metal coating layer having a final thickness lower than the predetermined initial thickness are obtained.

Preferably, as illustrated by the corresponding block of the diagram of figure 1, such a drawing step of the coated core is carried out in an emulsion bath, for example containing a lubricating oil conventional *per se,* and preferably by means of drawing dies made of tungsten carbide, which are also conventional *per se.*

The drawing of the coated core is facilitated by the deformability characteristics of the brass, essentially comprising α phase brass, obtained by means of the above-mentioned plasma deposition technique.

At the end of such a drawing step of the method of the invention, a metal wire uniformly and homogeneously coated with a metal coating layer is obtained.

Finally, a further stranding step of a plurality of coated wires obtained as described above allows to obtain a cord intended to reinforce elastomeric materials, such as for example the belt layers of a tire.

In accordance with an alternative embodiment of the method of the invention, in order to carry out the deposition step of the metal coating layer, two cathodes are provided in each vacuum deposition chamber, which allows to double the deposition rates with respect to the rates which can be achieved by the use of a single cathode. In the case in which two plate-shaped cathodes are provided, these are arranged parallel to each other and the wire to be coated is conveyed in an intermediate position between the cathodes at a predetermined distance therefrom, preferably comprised between about 1 and 10 cm.

In accordance with a preferred embodiment of the metal wire of the present disclosure is intended to reinforce elastomeric materials, of the type comprising a metal core and a metal coating layer, the coating layer may comprise a ternary metal alloy, such as for example Cu-Zn-Mn, preferably having a composition 63% Cu, 34% Zn, 3% Mn.

In order to deposit a metal coating layer of such a type on a metal core, for example made of steel, two alternative embodiments of the method of the invention may, for example, be provided.

In accordance with a first embodiment, the method provides a deposition step of the coating layer on the core by means of the sputtering technique in a way completely analogous to the way described above with reference to the deposition of a brass layer, the only difference being the composition of the cathode, which in such a case consists of the above-mentioned ternary alloy of the desired composition.

In accordance with a second embodiment, the method provides two consecutive deposition steps by means of the sputtering technique or by another plasma deposition technique. More precisely, in a first step, a brass layer is deposited on the core using a corresponding brass cathode whereas, in a second step, a layer of manganese is deposited on the brassed core using a corresponding manganese cathode.

As an alternative to manganese, other chemical elements, analogously intended to increase the corrosion resistance of the wire and the adhesion thereof to the elastomeric material, in particular the adhesion after ageing, such as for example cobalt, tin, molybdenum, iron, may be deposited.

Independently of the nature of the metal coating layer, when the coating of the core is obtained by means of two consecutive deposition steps, a first deposition step of a metal coating consisting of a binary alloy and a second deposition step of a single component coating, the initial thickness of the coating layer made of binary alloy is preferably comprised between about 0.5 and about 2 µm, whereas the initial thickness of the single component coating layer is preferably comprised between about 0.01 and about 0.2 µm.

Each of the above-mentioned steps of the method of the invention may be carried out simultaneously on a plurality of wires.

The invention is further described by way of the following illustrative examples.

### EXAMPLE 1

A steel wire rod, having a diameter of about 5.5 mm, was subjected to a descaling step and to a dry drawing - at the end of which the wire core having an initial diameter equal to about 1.4 mm was obtained - in a substantially continuous manner.

Subsequently, an electrolytically pickling of the core with sulfuric acid was carried out. In particular, the core was pickled by conveying the same in a sulfuric acid bath arranged downstream of the descaling position in a substantially continuous manner. The core was successively washed by conveying the core in water, said washing step being provided downstream of the pickling bath.

Successively, a patenting thermal treatment of the core, consisting of a heating step in a furnace at a temperature of about 950°C and of a subsequent cooling step in air at a temperature of about 550°C, was carried out in a substantially continuous manner. The exit rate of the core from the furnace was equal to about 36 m/min.

Subsequently, the steel core was fed, in a substantially continuous manner, into a first pre-chamber containing argon at about 0.5 mbar.

Subsequently, the core was conveyed, in a substantially continuous manner, to a vacuum deposition chamber such as the vacuum deposition chamber described above, in particular containing, as carrier gas, argon at a pressure of about 10⁻³ mbar, and comprising a cathode of tubular shape having a diameter equal to about 30 mm, consisting of brass having a copper content of 64% by weight and 36% by weight of zinc. The steel core was fed in a substantially continuous manner into such vacuum deposition chamber at a speed of about 36 m/min. A brass coating layer having an initial thickness equal to about 1.4 µm was deposited on the steel core in a substantially continuous manner.

For such a purpose, after a pressure of about 10⁻³ mbar was set within the vacuum deposition chamber, the core (i.e. the anode) was introduced into the tubular cathode of brass at a speed of about 36 m/min and was slid more times by means of the feedback means within the tubular cathode of brass until the above-mentioned initial coating thickness was achieved. The distance between the cathode and the anode was maintained equal to about 29 mm.

More specifically, a voltage equal to about 379 V and a current equal to about 2.74 A were used. With such preferred voltage and current values and with the above-mentioned preferred value of gas pressure, a deposition rate of the brass equal to about 800 nm/min was achieved.

Subsequently, the coated steel core was conveyed, in a substantially continuous manner, in a second pre-chamber containing argon at a pressure of about 0.5 mbar and arranged downstream of the vacuum deposition chamber.

The steel core was then drawn in a substantially continuous manner in a bath containing a lubricating oil (it is an emulsion in water of 10% by weight of a lubricating agent mentioned above) by means of drawing dies made of tungsten carbide, until a core having a final diameter equal to about 0.25 mm and a metal coating layer having a final thickness equal to about 0.2 µm were obtained.

The drawing of the core thus coated was facilitated thanks to the deformability characteristics of the brass coating which, by a X-ray diffraction analysis, appeared to consist only of α phase.

At the end of the above-mentioned drawing step, a steel wire uniformly and homogeneously coated with brass was obtained.

An atomic absorption spectroscopy (AAS) analysis carried out on steel wires coated with a brass coating layer produced in accordance with the embodiment of the method illustrated above has shown that the copper content of the brass coating layer was comprised in the range 63.5-64.5% by weight in the axial direction of the wire.

A scanning electron microscope (SEM) analysis of the same wires has shown that the copper content of the brass coating layer was comprised between 63-65% by weight in the radial direction of the wire.

Furthermore, an AAS analysis of the same wires has shown that the variation by weight of the amount of brass in the coating layer was equal to about ±0.15 g of brass/kg of steel both in the axial direction and in the radial direction of the wire.

Finally, the nature and the composition of the coating layer being the same, mechanical tensile strength tests have shown an increase of the mechanical resistance of the wires produced by the method of the invention equal to 5-10% with respect to the resistance shown by the wires produced by the methods of the prior art comprising an electrodeposition step.

Furthermore, a further stranding step of a plurality of steel wires coated with brass obtained as described above was provided to obtain a cord reinforcing elastomeric materials, such as for example the belt layers of a tire.

In a way known *per se,* cords produced in accordance with the method of the invention were incorporated in articles of elastomeric materials, such as semi-finished products intended for the manufacture of tires, tubes, conveyor belts, transmission belts and cables.

### EXAMPLE 2

A steel wire rod, having a diameter of about 5.5 mm, was subjected to a descaling step as in Example 1.

After the descaling step, an electrolytically pickling of the wire rod with sulfuric acid and a subsequent washing in water were carried out as described in Example 1.

The rod so pickled and washed was dried and submitted to a dry drawing - at the end of which a wire core having an initial diameter equal to about 1.4 mm was obtained - in a substantially continuous manner.

Successively, a patenting thermal treatment, a deposition and a wet drawing step were carried out as described in Example 1.

A further stranding step of a plurality of steel wires coated with brass obtained as described above was provided to obtain a cord reinforcing elastomeric materials, such as for example the belt layers of a tire.

In a way known *per se,* cords produced in accordance with the method of the invention were incorporated in articles of elastomeric materials, such as semi-finished products intended for the manufacture of tires, tubes, conveyor belts, transmission belts and cables.

### EXAMPLE 3

A core of steel wire having an initial diameter equal to about 1.4 mm was obtained as described in Example 1.

Subsequently, the steel core was superficially treated and patented as described in Example 1.

The exit rate of the core from the furnace was equal to about 36 m/min.

The steel core was fed into a first pre-chamber and then into a vacuum deposition chamber as described in Example 1, with the exception that the vacuum deposition chamber comprised a plurality of rectangular-shaped cathodes (45 cm x 7 cm), consisting of brass having a copper content of 63.5% by weight and 36.5% by weight of zinc. The steel core was fed in a substantially continuous manner into such a vacuum deposition chamber at a speed of about 36 m/min and a brass coating layer having an initial thickness equal to about 1.5 µm was then deposited on the steel core in a substantially continuous manner by means of the magnetron sputtering technique.

For such a purpose, after a pressure of about 3·10⁻³ mbar was set within the vacuum deposition chamber, the core (i.e. the anode) was passed more times - by means of the feedback means - parallel to the rectangular-shaped cathode at a speed of about 36 m/min until the above-mentioned initial coating thickness was achieved. The distance between the cathode and the anode was maintained equal to about 29 mm.

More specifically, a voltage equal to about 369 V and a current equal to about 2.64 A were used. With such preferred values of voltage and current and with the above-mentioned preferred value of gas pressure, a deposition rate of the brass equal to about 800 nm/min was achieved.

Subsequently, in accordance with a third step of the method of the invention, the coated steel core was drawn in a substantially continuous manner in a bath containing a lubricating oil using drawing dies of tungsten carbide, until a final diameter equal to about 0.25 mm and a metal coating layer having a final thickness equal to about 0.2 µm were obtained.

The drawing of the core thus coated was facilitated thanks to the deformability characteristics of the brass coating which, by an X-ray diffraction analysis, appeared to consist only of α phase.

At the end of the above-mentioned drawing step, a steel wire uniformly and homogeneously coated with brass was obtained.

### EXAMPLE 4

Two cores of steel wire having an initial diameter equal to about 1.4 mm were prepared as described with reference to Example 1.

Successively, the steel cores were superficially treated and patented as described with reference to Example 1.

The exit rate of the core from the furnace was equal to about 36 m/min.

The steel cores were fed in succession into a first pre-chamber and into a first vacuum deposition chamber as described in Example 1 with the exception that the first vacuum deposition chamber comprised two cathodes of tubular shape comprising brass having a copper content of 64% by weight and 35.5% by weight of zinc and further comprising 0.5% by weight of phosphorous.

A second pre-chamber was arranged downstream of the first vacuum deposition chamber and a second vacuum deposition chamber was arranged downstream of the second pre-chamber. The magnetron of the second vacuum deposition chamber was put in a stand by mode.

Furthermore, a third pre-chamber was arranged downstream of the second vacuum deposition chamber.

The first and the second vacuum deposition chambers were set at a pressure of about 5·10⁻² mbar. The first, second and third pre-chambers contained argon at a pressure of about 0.5 mbar.

The steel cores were fed parallel in a substantially continuous manner into the first pre-chamber and into the first vacuum deposition chamber at a speed of about 36 m/min. In the first vacuum deposition chamber a brass coating layer having an initial thickness equal to about 1.5 µm was deposited on each of the steel cores in a substantially continuous manner by means of the magnetron sputtering technique.

For such a purpose, after a pressure of about 5·10⁻² mbar was set within the first vacuum deposition chamber, the cores (i.e. the anodes) were respectively introduced in the tubular cathodes of brass at a speed of about 36 m/min and were slid more times by means of the feedback means within the respective tubular cathode of brass until the above-mentioned initial coating thickness was achieved. The distance between the cathode and the anode was maintained equal to about 30 mm.

More specifically, a voltage equal to about 387 V and a current equal to about 3.36 A were used. With such preferred voltage and current values and with the above-mentioned preferred value of gas pressure, a deposition rate of the brass equal to about 800 nm/min was achieved.

The steel cores leaving the third pre-chamber were then drawn in a substantially continuous manner in a bath containing a lubricating oil using drawing dies made of tungsten carbide, until cores having a final diameter equal to about 0.25 mm and metal coating layers having a final thickness equal to about 0.2 µm were obtained.

At the end of the above-mentioned drawing step, two steel wires uniformly and homogeneously coated with brass were obtained.

The drawing of the cores thus coated was improved because, in addition to the fact that the brass consisted only of α phase, as detected by an X-ray diffraction analysis, the phosphorous within the coating layer further facilitated the cold deformability during drawing.

## Claims

1. A method for producing a metal wire for reinforcing an elastomeric material, the metal wire comprising a metal core and a metal coating layer, said core having a predetermined initial diameter, the method comprising the steps of:
a) submitting said metal core to at least one surface treatment for predisposing the surface of the core to being coated with said coating layer;
b) thermally treating said core;
c) depositing said metal coating layer to a predetermined initial thickness on said core by means of a plasma deposition technique; and
d) drawing the coated core until the core has a final diameter smaller than said predetermined initial diameter and the metal coating layer has a final thickness smaller than said predetermined initial thickness.

2. The method according to claim 1, wherein said surface treatment, thermal treatment, deposition and drawing steps are carried out in a substantially continuous manner.

3. The method according to claim 2, wherein said core is conveyed through a sequence of respective surface treatment, thermal treatment, deposition and drawing positions at a speed comprised in the range from about 10 to about 80 m/min.

4. The method according to claim 1, wherein the surface treatment step comprises the step of pickling said core into a pickling bath and washing the pickled core into water.

5. The method according to claim 4, further comprising the step of drying the washed core.

6. The method according to claims 5, wherein said drying step is carried out by means of a least one blower.

7. The method according to claim 1, further comprising the step of dry drawing said core before said thermal treatment.

8. The method according to claim 1, wherein said plasma deposition technique is selected from the group comprising: sputtering, evaporation by voltaic arc, plasma spray and plasma enhanced chemical vapor deposition (PECVD).

9. Method according to claim 1 or 8, wherein said step of depositing the metal coating layer on said core is carried out in at least one vacuum deposition chamber at a first predetermined pressure.

10. The method according to claim 9, wherein the step of depositing the metal coating layer on said core is carried out a plurality of times.

11. The method according to claim 9, wherein said first predetermined pressure is comprised in the range from about 10⁻³ to about 10⁻¹ mbar.

12. The method according to claim 9, further comprising the step of conveying said core in at least one pre-chamber at a second predetermined pressure higher than said first predetermined pressure, said pre-chamber being arranged upstream of said at least one vacuum deposition chamber.

13. The method according to claim 12, wherein said second predetermined pressure is comprised between about 0.2 mbar to about 10 mbar.

14. The method according to claim 1, further comprising the preliminary steps of descaling a wire rod and of dry drawing said rod so as to obtain said core having a predetermined initial diameter.

15. The method according to claim 1, wherein the coating layer is made of a metal material different from the metal material of the core.

16. The method according to claim 1, wherein said core is made of steel.

17. The method according to claim 1, wherein said coating metal is selected from the group comprising: copper, zinc, manganese, cobalt, tin, molybdenum, iron and alloys thereof.

18. The method according to claim 17, wherein said coating metal is brass.

19. The method according to claim 18, wherein the brass has a copper content of from about 60 to about 72% by weight.

20. The method according to claim 15, wherein said coating metal further comprises a predetermined amount of a lubricating agent.

21. The method according to claim 1, wherein said initial thickness of the metal coating layer is at least about 0.5 µm.

22. The method according to claim 21, wherein said initial thickness of the metal coating layer is comprised between about 0.5 and about 2 µm.

23. The method according to claim 1, wherein said drawing step causes the final diameter of the core to be reduced of about 75-95% with respect to the initial diameter of the core.

24. The method according to claim 23, wherein the final diameter of the core is comprised in the range from 0.10 to 0.50 mm.

25. The method according to claim 1 or 23, wherein said drawing step causes the final thickness of the coating layer to be reduced of about 75-95% with respect to the initial thickness of the coating layer.

26. The method according to claim 25, wherein the final thickness of the metal coating claim the the layer is comprised in the range from 80 to 350 nm.

27. The method according to claim 1, wherein said initial diameter of the core is comprised between about 0.85 and about 3 mm.

28. The method according to claim 1 or 25, wherein said initial thickness of the coating layer is comprised between about 0.5 and about 2 µm.

## Patentansprüche

1. Verfahren zum Herstellen eines Metalldrahts zum Verstärken eines elastomeren Materials, wobei der Metalldraht einen Metallkern und eine Metallüberzugsschicht aufweist, der Kern einen vorgegebenen Anfangsdurchmesser aufweist, und das Verfahren die Schritte umfasst:
a) den Metallkern mindestens einer Oberflächenbehandlung Unterwerfen zum Prädisponieren der Oberfläche des Kerns zur Beschichtung mit der Überzugsschicht;
b) thermisches Behandeln des Kerns;
c) zu einer vorgegebenen Anfangsdicke Abscheiden der Metallüberzugsschicht auf dem Kern mittels einer Plasmaabscheidungstechnik; und
d) Ziehen des beschichteten Kerns, bis der Kern einen Enddurchmesser aufweist, der kleiner ist als der vorgegebene Anfangsdurchmesser, und die Metallüberzugsschicht eine Enddicke aufweist, die kleiner ist als die vorgegebene Anfangsdicke.

2. Verfahren nach Anspruch 1, bei dem der Oberflächenbehandlungs-, der thermische Behandlungs-, Abscheide- und Ziehschritt auf eine im Wesentlichen kontinuierliche Art durchgeführt werden.

3. Verfahren nach Anspruch 2, bei dem der Kern mit einer Geschwindigkeit, die in einem Bereich von ungefähr 10 bis ungefähr 80 m/min enthalten ist, durch eine Sequenz von jeweiligen Oberflächenbehandlungs-, thermischer Behandlungs-, Abscheidungs- und Ziehpositionen befördert wird.

4. Verfahren nach Anspruch 1, bei dem der Oberflächenbehandlungsschritt den Schritt des Beizens des Kerns in einem Beizbad und des Waschens des gebeizten Kerns in Wasser umfasst.

5. Verfahren nach Anspruch 4, das ferner den Schritt des Trocknens des gebeizten Kerns umfasst.

6. Verfahren nach Anspruch 5, bei dem der Trocknungsschritt mittels mindestens eines Gebläses ausgeführt wird.

7. Verfahren nach Anspruch 1, das ferner den Schritt des vor der thermischen Behandlung Trockenziehens des Kerns umfasst.

8. Verfahren nach Anspruch 1, bei dem die Plasmaabscheidungstechnik aus der Gruppe ausgewählt ist, die besteht aus: Sputtern, Verdunsten durch Lichtbogen, Plasmasprühverfahren und plasmaunterstützte chemische Gasphasenabscheidung ("plasma enhanced chemical vapour deposition"; PECVD).

9. Verfahren nach Anspruche 1 oder 8, bei dem der Schritt des Abscheidens der Metallüberzugsschicht auf dem Kern in mindestens einer Vakuumabscheidekammer bei einem ersten vorgegebenen Druck ausgeführt wird.

10. Verfahren nach Anspruch 9, bei dem der Schritt des Abscheidens der Metallüberzugsschicht auf dem Kern mit einer Vielzahl von Wiederholungen ausgeführt wird.

11. Verfahren nach Anspruch 9, bei dem der erste vorgegebene Druck in dem Bereich von ungefähr 10⁻³ bis ungefähr 10⁻¹ mbar enthalten ist.

12. Verfahren nach Anspruch 9, das ferner den Schritt des Beförderns des Kerns in mindestens eine Vorkammer bei einem zweiten vorgegebenen Druck, der höher ist als der erste vorgegebene Druck, umfasst, wobei die Vorkammer stromaufwärts von der mindestens einen Vakuumabscheidekammer angeordnet ist.

13. Verfahren nach Anspruch 12, bei dem der zweite vorgegebene Druck zwischen ungefähr 0.2 mbar und ungefähr 10 mbar enhalten ist.

14. Verfahren nach Anspruch 1, das ferner die vorbereitenden Schritte des Entzunderns eines Walzdrahts und des Trockenziehens des Drahts umfasst, um den Kern mit einem vorgegebenen Anfangsdurchmesser zu erhalten.

15. Verfahren nach Anspruch 1, bei dem die Überzugsschicht aus einem Metall hergestellt ist, das sich von dem Metallmaterial des Kerns unterscheidet.

16. Verfahren nach Anspruch 1, bei dem der Kern aus Stahl hergestellt ist.

17. Verfahren nach Anspruch 1, bei dem das Überzugsmetall ausgewählt ist aus der Gruppe, die besteht aus: Kupfer, Zink, Mangan, Kobalt, Zinn, Molybdän, Eisen und Legierungen davon.

18. Verfahren nach Anspruch 17, bei dem das Überzugsmetall Messing ist.

19. Verfahren nach Anspruch 18, bei dem das Messing einen Kupfergehalt von ungefähr 60 bis ungefähr 70% Gewichtsanteil aufweist.

20. Verfahren nach Anspruch 15, bei dem der Überzugsmetall ferner eine vorgegebene Menge eines Schmiermittels aufweist.

21. Verfahren nach Anspruch 1, bei dem die Anfangsdicke der Metallüberzugsschicht mindestens ungefähr 0.5 µm beträgt.

22. Verfahren nach Anspruch 21, bei dem die Anfangsdicke der Metallüberzugsschicht zwischen ungefähr 0.5 und ungefähr 2 µm enthalten ist.

23. Verfahren nach Anspruch 1, bei dem der Ziehschritt bewirkt, dass der Enddurchmesser des Kerns mit ungefähr 75-95% in Bezug auf den Anfangsdurchmesser des Kerns reduziert wird.

24. Verfahren nach Anspruch 23, bei dem der Enddurchmesser des Kerns in dem Bereich von 0.10 bis 0.50 mm enthalten ist.

25. Verfahren nach Anspruch 1 oder 23, bei dem der Ziehschritt bewirkt, dass der Enddurchmesser der Überzugsschicht mit ungefähr 75-95% in Bezug auf den Anfangsdurchmesser der Überzugsschicht reduziert wird.

26. Verfahren nach Anspruch 25, bei dem die Enddicke der Metallüberzugsschicht in dem Bereich von 80 bis 350 nm enhalten ist.

27. Verfahren nach Anspruch 1, bei dem der Anfangsdurchmesser des Kerns zwischen ungefähr 0.85 und ungefähr 3 mm enthalten ist.

28. Verfahren nach Anspruch 1 oder 25, bei dem die Anfangsdicke der Überzugsschicht zwischen ungefähr 0.5 und ungefähr 2 µm enthalten ist.

29. Verfahren zum Herstellen eines Metallgurts zum Verstärken eines elastomeren Materials, wobei das Verfahren den Schritt des Herstellens einer Vielzahl an Drähten nach einem der Ansprüche 1 bis 28 und den Schritt des Verseilens der Vielzahl an Drähten umfasst.

## Revendications

1. Procédé de fabrication d'un fil métallique destiné à renforcer un matériau élastomère, le fil métallique comprenant une âme métallique et une couche de revêtement en métal, ladite âme présentant un diamètre initial prédéterminé, le procédé comprenant les étapes de :
a) soumettre ladite âme métallique à au moins un traitement de surface de manière à préparer la surface de l'âme en vue d'être revêtue de ladite couche de revêtement ;
b) traiter thermiquement ladite âme ;
c) déposer ladite couche de revêtement en métal avec une épaisseur initiale prédéterminée sur ladite âme au moyen d'une technique de dépôt par plasma ; et
d) étirer l'âme revêtue jusqu'à ce que l'âme présente un diamètre final inférieur audit diamètre initial prédéterminé et que la couche de revêtement en métal présente une épaisseur finale inférieure à ladite épaisseur initiale.

2. Procédé selon la revendication 1, dans lequel les étapes de traitement de surface, de traitement thermique, de dépôt et d'étirage sont réalisées d'une manière sensiblement continue.

3. Procédé selon la revendication 2, dans lequel ladite âme est acheminée à travers une séquence de positions respectives de traitement de surface, de traitement thermique, de dépôt et d'étirage à une vitesse comprise entre environ 10 et environ 80 m/min.

4. Procédé selon la revendication 1, dans lequel l'étape de traitement de surface comprend l'étape de décaper ladite âme dans un bain de décapage et de laver à l'eau l'âme décapée.

5. Procédé selon la revendication 4 comprenant, en outre, l'étape de sécher l'âme lavée.

6. Procédé selon la revendication 5, dans lequel ladite étape de sécher est réalisée au moyen d'au moins un ventilateur.

7. Procédé selon la revendication 1 comprenant, en outre, l'étape d'étirer à sec ladite âme préalablement audit traitement thermique.

8. Procédé selon la revendication 1, dans lequel ladite technique de dépôt par plasma est sélectionnée parmi le groupe comprenant : la pulvérisation, l'évaporation par arc voltaïque, la projection au plasma, et le dépôt chimique en phase vapeur assisté par plasma (PECVD).

9. Procédé selon la revendication 1 ou 8, dans lequel ladite étape de déposer la couche de revêtement en métal sur ladite âme est réalisée dans au moins une chambre de dépôt sous vide à une première pression prédéterminée.

10. Procédé selon la revendication 9, dans lequel l'étape de déposer la couche de revêtement en métal sur ladite âme est réalisée plusieurs fois.

11. Procédé selon la revendication 9, dans lequel ladite première pression prédéterminée est comprise entre environ 10⁻³ et environ 10⁻¹ mbar.

12. Procédé selon la revendication 9 comprenant, en outre, l'étape d'acheminer ladite âme dans au moins une préchambre à une deuxième pression prédéterminée plus élevée que ladite première pression prédéterminée, ladite préchambre étant disposée en amont de ladite au moins une chambre de dépôt sous vide.

13. Procédé selon la revendication 12, dans lequel ladite deuxième pression prédéterminée est comprise entre environ 0,2 mbar et environ 10 mbar.

14. Procédé selon la revendication 1 comprenant, en outre, les étapes préliminaires de décalaminer un fil machine et d'étirer à sec ledit fil machine de manière à obtenir ladite âme présentant un diamètre initial prédéterminé.

15. Procédé selon la revendication 1, dans lequel la couche de revêtement est composée d'un matériau métallique différent du matériau métallique de l'âme.

16. Procédé selon la revendication 1, dans lequel ladite âme est en acier.

17. Procédé selon la revendication 1, dans lequel ledit métal de revêtement est sélectionné parmi le groupe comprenant : le cuivre, le zinc, le manganèse, le cobalt, l'étain, le molybdène, le fer et leurs alliages.

18. Procédé selon la revendication 17, dans lequel ledit métal de revêtement est en laiton.

19. Procédé selon la revendication 18, dans lequel le laiton contient entre environ 60 et environ 72% en poids de cuivre.

20. Procédé selon la revendication 15, dans lequel ledit métal de revêtement comprend en outre une quantité prédéterminée d'un agent lubrifiant.

21. Procédé selon la revendication 1, dans lequel ladite épaisseur initiale de la couche de revêtement en métal est au moins d'environ 0,5 µm.

22. Procédé selon la revendication 21, dans lequel ladite épaisseur initiale de la couche de revêtement en métal est comprise entre environ 0,5 et environ 2 µm.

23. Procédé selon la revendication 1, dans lequel ladite étape d'étirage engendre une réduction du diamètre final de l'âme d'environ 75-95% par rapport au diamètre initial de l'âme.

24. Procédé selon la revendication 23, dans lequel le diamètre final de l'âme est compris entre 0,10 et 0,50 mm.

25. Procédé selon la revendication 1 ou 23, dans lequel ladite étape d'étirage engendre une réduction de l'épaisseur finale de la couche de revêtement d'environ 75-95% par rapport à l'épaisseur initiale de la couche de revêtement.

26. Procédé selon la revendication 25, dans lequel l'épaisseur finale de la couche de revêtement en métal est comprise entre 80 et 350 nm.

27. Procédé selon la revendication 1, dans lequel ledit diamètre initial de l'âme est compris entre environ 0,85 et environ 3 mm.

28. Procédé selon la revendication 1 ou 25, dans lequel ladite épaisseur initiale de la couche de revêtement est comprise entre environ 0,5 et environ 2 µm.

29. Procédé de fabrication d'un câble métallique destiné à renforcer un matériau élastomère, ledit procédé comprenant l'étape de fabriquer une pluralité de fils conformément à l'une des revendications 1 à 28, et l'étape de toronner ladite pluralité de fils.
